Europäisches Patentamt

(19) European Patent Office

Office européen des brevets

(11) Publication number: 0 046 327
A1

# (12) EUROPEAN PATENT APPLICATION

(21) Application number: 81200926.4

(22) Date of filing: 20.08.81

(51) Int. Cl.³: B 41 M 3/14, G 03 F 5/22

(30) Priority: 20.08.80 NL 8004703

(43) Date of publication of application: 24.02.82
Bulletin 82/8

(84) Designated Contracting States: AT BE CH DE FR GB IT LI LU NL SE

(71) Applicant: DE NEDERLANDSCHE BANK N.V., P.O. Box 98, NL-1000 AB Amsterdam (NL)

(72) Inventor: Koeze, Peter, Nieuwe Gracht 39b, Utrecht (NL)

(74) Representative: Kooy, Leendert Willem et al, Octrooibureau Vriesendorp & Gaade Dr. Kuyperstraat 6, NL-2514 BB The Hague (NL)

(54) Printed matter having elements to indicate counterfeiting, and method for manufacturing such printed matter.

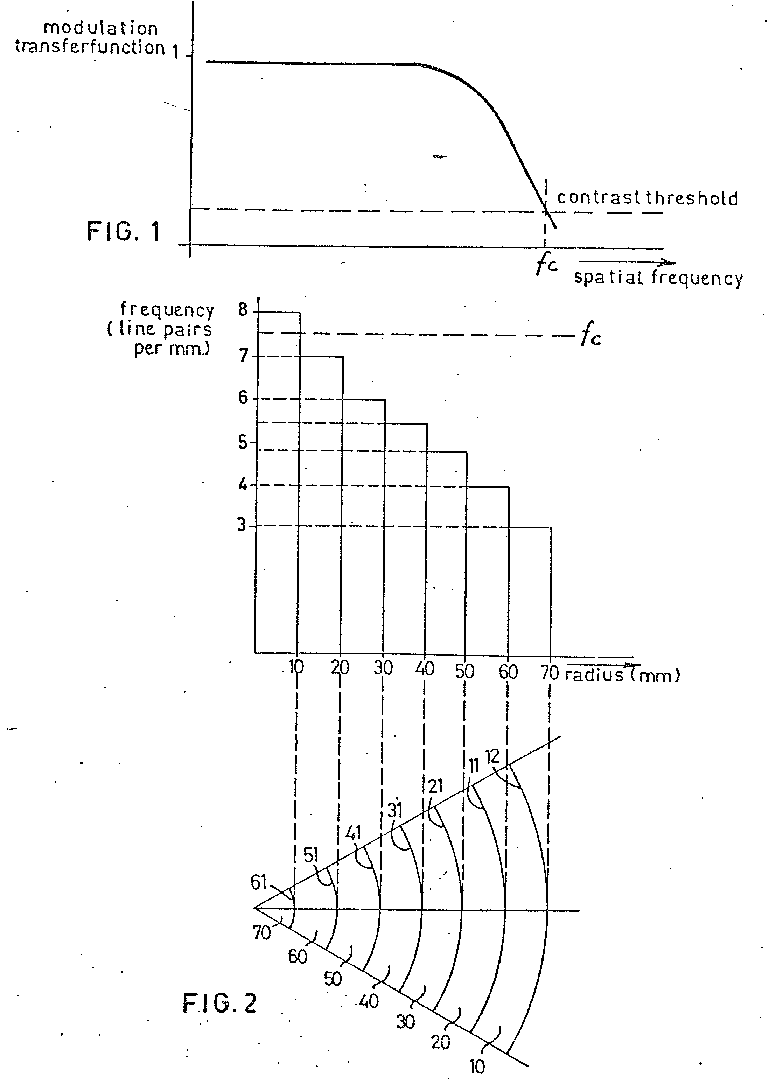

(57) Printed matter comprising a plurality of elements applied in printing and causing in a half tone reproduction a moiré pattern each element being made up of alternatingly print zones and blank zones being delimited by portions of curved lines, said curved lines being comprised in a set of curved lines which set is a topological equivalent of a set of concentric circles (61, 51, 41, 31, 21, 11, 1) wherein the sum of the areas of the print zones equals the sum of the areas of the blank zones. A super element accordingly comprises two or more elements, each element forming a track, the zones in the respective elements or tracks (10, 20, 30, 40, 50, 60, 70) being different as to their width, each element thus representing a different spatial frequency as shown in the figure 2. A method for manufacturing printed matter is characterized in that the print area in an element or super element equals the non-print blank area therein.

- 1 -

Printed matter having elements to indicate counterfeiting, and method for manufacturing such printed matter.

The invention relates to printed matter having one or more elements applied in printing, said elements causing a visible moiré pattern in a halftone reproduction of the said printed matter, an element of a first class being defined by at least a part of a set of concentric circles, an element of this first class comprising zones being delimited by successive circles and alternately being prints and blanks.

Similar printed matter has been disclosed in British patent No. 1 138 011. Each element in the disclosed printed matter causing due to interference with the half tone screen being used at reproduction a visible moiré effect in the reproduction, is a line arrangement which is comprised in an array so that at least one of said elements is generating by interference the moiré pattern aimed at. Further the British patent discloses indications about the configuration of each of the elements based upon assumptions as to the most common spatial frequency values in half tone screens, for which numbers of 3-20 line pairs per millimeter are stated, and upon the orientation of a main axis in the half tone screen which is assumed to be within an angular distance of $10^{\circ}$ to the orientation of lines in at least one of the elements. An element of the first class as specified in the preamble and defined by circles, can easily meet the second condition. On the other hand

- 2 -

0046327

a line arrangement having a spacing amounting to more than 8 line pairs per millimeter, is not easily to realize by intaglio printing as already being mentioned in the cited British patent.

French Patent 1 335 655 discloses printed matter having to ensure security a background already showing a configuration of moiré patterns. In contradistinction to the present invention this known configuration of moiré patterns is a proof of authenticity, not of counterfeiting.

The moiré pattern generated by the printed matter element at counterfeiting using a half tone screen must be easily discernible to be effective. Human visual perception as well as the quality of a reproduction of printed matter can be discussed using the optical modulation transfer function of the perception system and the reproduction system respectively. Such a discussion is to follow. In visual perception with regard to the moiré effect in the printed matter configuration the portion of the image area, wherein the moiré pattern arises when counterfeiting as discussed, has importance. The larger this portion, the more it strikes the eye that the image area comprises a moiré pattern. However, the fact that one element or several elements comprise a large portion of the image area, is not always compatible with the communication of textual and pictorial information in the image area, which is the essential object of printed matter.

The present invention has the object to provide printed matter of the type described in the preamble which when counterfeited by means of a half tone reproduction shows a moiré pattern with maximal contrast to make the generated effect opti-mally conspicuous not taking into account the relative size of the elements.

Moreover, the invention has the object that when using a counterfeiting technique other than half tone reproduction the counterfeited prints show maximal contrast jumps arising in the image area and perceptibly damaging the quality of the communication of information to be performed by the printed matter.

According to the present invention the printed matter is characterized in that the sum of the areas of the printed zones in an element of the first class equals the sum of the areas of the blank zones and in that an element of a second class is defined by at least a part of a set of closed curves being topologically equivalent with concentric circles comprised in a set of concentric circles for which it is equally valid that the sum of the areas of printed zones delimited by successive circles equals the sum of the areas of the blank zones.

According to the invention the limited size of the elements is attained in particular in that two or more elements are combined in a super element, wherein each element forms a track, the zones in the respective tracks being different as to their widths.

The present invention is hereafter illustrated in a description of a preferred embodiment of printed matter wherein a plurality of elements of the first and/or the second class are combined into a super element. Where there is question in this description of a line pair, reference is made to a pair formed by a curve shaped solid print and a ditto blank area in juxta/position thereto, selected from a sequence of alternately printed and blank areas. The term is derived from a method for judging contrasts in the presentation of information transmitted by printed matter.

The description refers to a drawing.
Fig. 1 shows a plot against spatial frequency of the modulation transfer function of a reproduction system.

Fig. 2 represents a portion of an embodiment of a super element according to the invention.

Fig. 3 shows a portion of a further embodiment of a super element according to the invention.

A half tone screen as applied by a counterfeiter when counterfeiting by means of half tone reproduction of the authentic printed matter, can be specified by its symmetry and by its spatial frequency. Rotation-symmetry of the said elements, and in particular circular symmetry, renders the elements insensitive for preferred orientations, such as main axes, in the half tone reproduction screen. It has been found that in this respect a six-fold symmetry of the elements already proves satisfactory. Therefor an element can be specified as defined by at least a part of a set of closed curves being topologically equivalent with concentric circles comprised in a set of concentric circles for which it is true that each of the zones delimited by successive circles has the same width.

To be prepared for all spatial frequencies present in half tone screens basically each element should comprise the range of spatial frequencies of from zero to infinite. Typically for the quality of a reproduction means is, as said before, its optical modulation transfer function which is defined in the spatial frequency space and which is significantly different from zero where a spatial frequency is passed on by the reproduction means into the reproduction. Beyond a characteristic frequency, that is the cut-off frequency, the transfer function of the reproduction means will not be significantly different from zero. Using half tone screen reproduction the frequency to be assigned to the screen also is the cut-off frequency of the reproduction system. The cut-off frequency will never be higher than the frequency of the used half tone reproduction screen, which causes very finely printed portions of the image area to be suppressed by half tone reproduction. This means that in a similar reproduction/in very finely printed portions of an image area no details will be visually perceptible. In connection herewith it is remarked that the moiré effect can be a visual aid by making the presence of very fine details noticeable by means of the "magnified" interference pattern.

In fig. 1 a plot is shown of the optical modulation transfer function for a reproduction means with cut-off frequency $f_c$. In this plot the contrast threshold of the reproduction means expressed as a level of the modulation transfer function, has also been indicated.

At a predetermined spatial frequency the contrast is maximal when the modulation-transfer function has a maximal level. This level can amount to, per definition, 1, viz. when in a line pair one line precisely covers 50% of the area covered by said pair.

The demands resulting from the above mentioned considerations have been realized simply and effectively in the printed matter that will now be described as a preferred embodiment of the invention. The printed matter comprises a super element composed of 7 elements which have the form of concentric tracks the zones in the various tracks being different as to their widths. The comparison of the width can take place in a randomly selected circle sector of the super element.

Fig. 2 shows such a circle sector of the super element having tracks 10, 20, 30, 40, 50, 60 and 70. In track 10 is found the lowest value as to the spatial frequency which is connected with the

0046327

-6-

respective widths of zones of the track within the sector, and in track 70 the highest value of the spatial frequency. This highest value of the spatial frequency to be found in the super element is chosen such that the highest expected cut-off frequency of any reproduction system is exceeded. In doing so Table A is listed stating for the tracks 10 through 70 the radius in mm of the respective inner circles 11 through 61, the spatial frequency in line pairs per mm of the zones in the respective tracks and the width of the zones in mm. The radius of the outer circle 12 of the track 10 amounts to 70 mm.

The spatial frequency values selected in this embodiment are close to those of commercially available half tone screens for reproduction purposes, which are plausible choices for use by a counterfeiter.

When a counterfeiter is using a half tone screen having an insufficiently high frequency, this will immediately be apparent in the thus produced printed matter which will present blank areas and at any rate areas without any detail, where this even strikes at casual examination.

TABLE A

| Track (fig. 2) | Radius of inner circle (mm) | Frequency (line pairs per mm) | Width of zones (mm) |
|---|---|---|---|
| 10 | 60 | 3.0 | 0.167 |
| 20 | 50 | 4.0 | 0.125 |
| 30 | 40 | 4.8 | 0.104 |
| 40 | 30 | 5.4 | 0.093 |
| 50 | 20 | 6.0 | 0.083 |
| 60 | 10 | 7.0 | 0.071 |
| 70 | 0 | 8.0 | 0.063 |

Fig. 2 shows separately by means of a bar chart which frequencies do occur in the various tracks of the upper element represented in this figure. It is assumed that the cut-off frequency $f_c$ of the reproduction means is between 7 and 8 line pairs per millimeter.

In practice it has appeared that aiming at a precise 50% ink cover of the substrate, causes the printing process producing printed matter as disclosed here, to slow down less than 10%.

The circular form of the tracks and the zones in the above specified example when calculated appears to allow for the ink cover necessary for obtaining an optimal contrast with the accuracy to be achieved in practice provided each zone in a track has the same width.

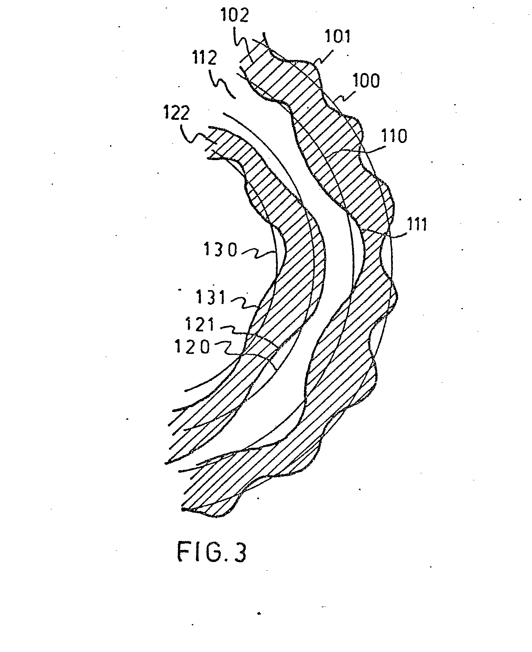

Fig. 3 shows a further preferred embodiment of printed matter according to the invention. It represents the option to leave circle-symmetry while maintaining the specified characteristics of the embodiment as described above. The areas of the zones delimited by curved lines such as 101, 111, 121 and 131 equally meet the requirements as stated with respect to the sum of their areas and the relation between print (shaded in fig. 3) and non-print blank areas (102, 122; 112 respectively). The curved lines are "variations" of circularly curved lines 100, 110, 120, 130. Of course fig. 3 is a very crude representation of printed matter displaying a fineness of 3 to 8 line pairs per mm. Such variations open the possibility to have securities, such as bank notes, printed according to the invention where an absolute circle-symmetry would be incompatible with the artistic rendering as intended by their designer.

0046327

-1-

CLAIMS:

1. Printed matter having one or more elements applied in printing, said elements causing a visible moiré pattern in a half tone reproduction of the said printed matter, an element of a first class being defined by at least a part of a set of concentric circles, an element of this first class comprising zones being delimited by successive circles and alternately being prints and blanks, characterized in that the sum of the areas of the printed zones in an element of the first class equals the sum of the areas of the blank zones and in that an element of a second class is defined by at least a part of a set of closed curves being topologically equivalent with concentric circles comprised in a set of concentric circles for which it is equally valid that the sum of the areas of printed zones delimited by successive circles equals the sum of the areas of the blank zones.

2. Printed matter according to claim 1, characterized in that two or more elements are connectedly combined in a super element, wherein each element forms a track, the zones in the various tracks being different as to their spatial frequencies.

3. A method for manufacturing printed matter according to claim 1 or 2, characterized in that the print area in an element or super element equals the non-print blank area therein.

0046327 13

FIG. 1

FIG. 2

FIG.3

European Patent
Office

**EUROPEAN SEARCH REPORT**

0046327

Application number

EP 81 20 0926

## DOCUMENTS CONSIDERED TO BE RELEVANT

| Category | Citation of document with indication, where appropriate, of relevant passages | Relevant to claim |
|---|---|---|
| D | GB - A - 1 138 011 (CANADIAN BANK NOTE) <br> * Page 3, line 129 to page 4, line 78; page 5, lines 27-94; figures 9-12,15; claims 1,2,8, 12,13 * | 1-3 |
| DA | FR - A - 1 335 655 (IMPRIMERIE CHAIX) | |

**CLASSIFICATION OF THE APPLICATION (Int. Cl.³)**

B 41 M    3/14
G 03 F    5/22

**TECHNICAL FIELDS SEARCHED (Int. Cl.³)**

B 41 M    3/14
G 03 F    5/22
B 44 F    1/12
B 42 D   15/02
G 03 F    5/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 16-11-1981 | PHILOSOPH |

EPO Form 1503.1  06.78